Europäisches Patentamt

European Patent Office

Office européen des brevets

(11) Publication number: 0 215 494

A1

# (12) EUROPEAN PATENT APPLICATION

(21) Application number: 86200967.7

(51) Int. Cl.⁴: H03K 3/037

(22) Date of filing: 02.06.86

(30) Priority: 18.09.85 US 777665

(43) Date of publication of application:
25.03.87 Bulletin 87/13

(84) Designated Contracting States:
DE FR GB IT NL

(71) Applicant: THE BOEING COMPANY
P.O. Box 3707 Mail Stop 7E-25
Seattle Washington 98124-2207(US)

(72) Inventor: McInturff, John Calvin
18958 Edgecliff Dr. S.W.
Seattle Washington 98166(US)
Inventor: Flynn, George Robert
230 Sumac Drive
Monroe Washington 98272(US)

(74) Representative: Hoijtink, Reinoud et al
OCTROOIBUREAU ARNOLD & SIEDSMA
Sweelinckplein 1
NL-2517 GK Den Haag(NL)

(54) Two-state memory device.

(57) A bi-stable memory device including a first input for receiving a binary input signal $I_1$, and a second input for receiving another binary input signal $I_2$. The device includes bi-stable logic circuitry, connected to the first and second inputs, which is operable in response to the $I_1$ and $I_2$ signals to generate from such signals first and second output response signals $R_1$ and $R_2$. For any and all binary values of the $I_1$ and $I_2$ signals, the $R_1$ output signal is always the binary complement of the $R_2$ output signal.

Fig. 2

## TWO-STATE MEMORY DEVICE

Technical Field

This device relates to memory devices such as "flip-flops" which are used in computers. More particularly, the invention relates to an improved two-state R-S type "flip-flop" memory device.

Background Art

It is known that many logic circuits in a computer can exhibit undesirable or anomalous behaviour even though the circuits by themselves are fault-free. For example, such undesirable behavior is most often manifested by an undesirable circuit output which is no more than a response to a given set of undesirable inputs. The problem therefore lies with the inputs and not with the circuit itself.

The well-known "NAND" and "NOR" type R-S flip-flops provide a typical example of the above-described behaviour. A person skilled in the art would be familiar with these flip-flops and would know that R typically denotes "Reset" and S typically denotes "Set".

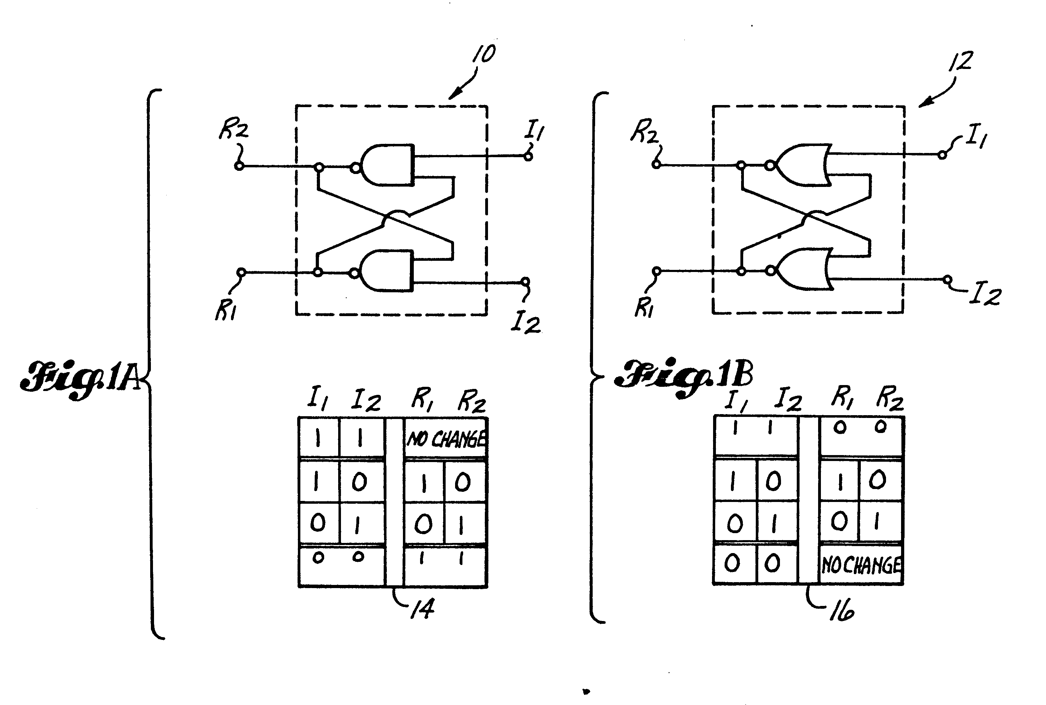

Referring now to Figs. 1A and 1B, therein is shown a typical NAND R-S flip-flop 10 and a typical NOR R-S flip-flop 12. Operation tables 14,16 are shown below each respective flip-flop. Each flip-flop 10,12 has a pair of independent inputs $I_1$ and $I_2$. Similarly, each flip-flop 10,12 also has a pair of outputs $R_1$ and $R_2$. The inputs $I_1, I_2$ receive signals in binary form that typically are a series of high and low voltages corresponding to binary "ones" and "zeroes". Such signals are sometimes input in conjunction with a clock signal, for example. Binary output signals are transmitted from the outputs $R_1$ and $R_2$. Since the flip-flops 10,12 have two inputs $I_1, I_2$ and two outputs $R_1, R_2$, they would be deemed two-state flip-flops by a person skilled in the art. Accordingly, the possible two-state binary input combinations $(I_1, I_2)$ for each flip-flop 10,12 are (1,1), (1,0), (0,1), or (0,0). These four pairs of input combinations are shown in the two left-hand columns in both tables 14 and 16.

The two-state response of the NAND flip-flop 10 is shown in the two right-hand columns of table 14. If the binary inputs $(I_1, I_2)$ of flip-flop 10 is (1,1), then the binary outputs $(R_1, R_2)$ will not change from the previous set of inputs, which were input earlier. If the binary inputs $(I_1, I_2)$ are either (1,0) or (0,1), then the inputs will be output in the sane two-state combination in which they were input, as shown in the right-hand column of table 14. Specifically, if $(I_1, I_2)$ is (1,0) then $(R_1, R_2)$ will be (1,0). Likewise, if $(I_1, I_2)$ is (0,1) then $(R_1, R_2)$ will be (0,1).

For the NAND flip-flop 10, the input combination (0,0) results in an output combination of (1,1). This is in effect a third state since these two outputs are not mutually exclusive, as they were in the previous three modes, and as they must be for two-state systems. This third state, however, can cause anomalous behaviour in the two-state system which utilizes this particular flip-flop. As a person skilled in the art would know, this third state is an undesirable output for an R-S flip-flop. Therefore, an input combination of (0,0) normally is not allowed in a system designed to use this type of device. The problem is that sometimes such a combination occurs anyway, through either system design error, system failures or because of other factors.

A similar problem also occurs with the NOR R-S flip-flop 12 shown in Fig. 1B. If flip-flop 12 has inputs $(I_1, I_2)$ of (0,0), then there will be no change in the outputs $(R_1, R_2)$. If the inputs $(I_1, I_2)$ are either (1,0) or (0,1), then the outputs $(R_1, R_2)$ are the same as the inputs in the manner shown in table 16. However, if the inputs $(I_1, I_2)$ are (1,1) then an undesirable third state output response of (0,0) will occur. This can similarly result in anomalous behaviour of the system using this type of flip-flop.

In the art, the flip-flops 10,12 are normally called bi-stable devices. This is because they are normally used to output exclusive outputs of a (1,0) or a (0,1). Systems utilizing these devices are designed so that the output $R_1$ should always be the complement of the output $R_2$, meaning that one will be "zero" and the other will be "one" in binary terms. Therefore, a system design requirement is that inputs of (0,0) for flip-flop 10 and (1,1) for flip-flop 12 are not allowed because they result in nonbi-stable outputs for each respective flip-flop. As was mentioned above, sometimes because of an error in system design, a system failure or for other reasons, non-allowed input combinations occur.

The problem, then, is to provide a memory device that has a truely bi-stable output i.e., an output of either (1,0) or (0,1), regardless of the independent binary values of the inputs $(I_1, I_2)$. Such a device, when used in connection with or to replace standard R-S flip-flops, eliminates the possible anomalous behaviour that can occur when undesirable inputs are received by such devices. At least to our knowledge, no device other than the present invention accomplishes this task.

## Disclosure of the Invention

The present invention provides a truly bi-stable memory device having a first input for receiving a binary input signal $I_1$, and a second input for receiving another binary input signal $I_2$. The two signals $I_1$ and $I_2$ are normally generated independently of each other. Logic circuitry means, connected to the first and second inputs, operates upon the input signals and generates first and second binary output response signals $R_1$ and $R_2$. The two output signals $R_1,R_2$ are mutually exclusive of each other. For any binary value of either the $I_1$ input signal or the $I_2$ input signal, the binary value of the $R_1$ output signal is always the complement of the generated $R_2$ output signal. This relationship in terms of Boolean algebra is as follows: $R_2 = \overline{R}_1$; and $\overline{R}_2 = R_1$, wherein $\overline{R}_1$ and $\overline{R}_2$ in Boolean terms means "not $R_1$," and "not $R_2$", respectively.

The logic circuitry means may include standard NAND or NOR R-S flip-flop circuitry. For example, in one embodiment of the invention, wherein a NAND flip-flop is used, the logic circuitry means also includes a first inhibit logic connected to one input of the NAND flip-flop, and a second inhibit logic connected to the other input of the flip-flop. Each inhibit logic has a pair of inputs. One input of the first inhibit logic is connected to the first input of the memory device for receiving the $I_1$ input signal. The second input of the first inhibit logic is connected to the second input of the device for receiving the other input signal $I_2$.

In similar fashion, the second inhibit logic has a pair of inputs, one of which is connected to the second input of the device, and the other of which is connected to the first input of the device.

In a second embodiment of the invention, the above-described NAND flip-flop may be replaced by a NOR flip-flop. In this latter embodiment the above-described first and second inhibit logic are appropriately altered in a manner to be described later.

In either one of the two embodiments, the two-state output responses $(R_1,R_2)$ are always mutually exclusive and thus truly bi-stable. As was previously noted, typical R-S flip-flops are often referred to as being bi-stable, but such flip-flops will not have a bi-stable output for certain undesirable inputs which result in third state outputs. In the present invention, if the input signals $(I_1,I_2)$ are complementary, meaning that $(I_1,I_2)$ will be either (1,0) or (0, 1), then the outputs $(R_1, R_2)$ will also be complementary as in the manner shown in the middle portions of tables 14, 16. Furthermore, in either embodiment of the invention described herein, if the inputs $(I_1, I_2)$ have the undesirable values of either (1, 1) for a NOR flip-flop, or (0, 0) for NAND flip-flop the outputs $(R_1, R_2)$ will still be complementary. Basically, both embodiments behave exactly as they did prior to receiving an unwanted input command. No matter what the input command, a bi-stable complementary output response is always generated, meaning that possible anomalous behaviour in a system utilizing the invention can be eliminated when undesirable input commands occur.

## Brief Description of the Drawing

Referring to the accompanying drawings, which are for illustrative purposes only, like reference numerals and letters refer to like parts throughout, and wherein:

Fig. 1A is a schematic view of a typical NAND R-S flip-flop having two inputs and two outputs, and includes at the lower portion thereof an operating table showing the flip-flop output response for four possible pairs of binary inputs;

Fig. 1B is a view much like Fig. 1A, but shows a schematic view of a typical NOR R-S flip-flop and includes the operating table therefor;

Fig. 2 is a schematic view of a first embodiment of the invention, and shows logic circuitry necessary to convert a NAND flip-flop into a truly bi-stable memory device; and

Fig. 3 is a schematic view of a second embodiment of the invention, and shows logic circuitry necessary to convert a NOR flip-flop into a truly bi-stable memory device.

## Best Mode for Carrying out the Invention

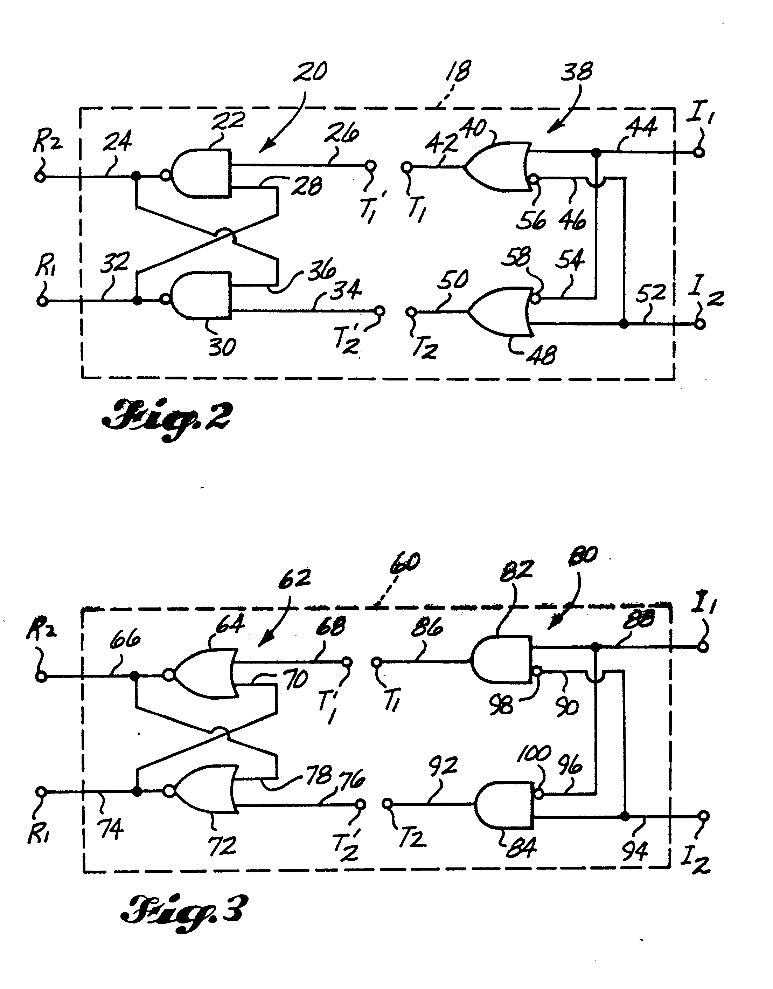

Referring now to the drawings, and first to Fig. 2, therein is shown a first embodiment 18 of a bi-stable memory device constructed in accordance with the present invention. The device 18 includes a first portion in the form of a typical NAND R-S flip-flop 20. The circuitry of the flip-flop 20 and its operation would be familiar to a person skilled in the art. Briefly, the flip-flop 20 includes a first NAND gate 22 having a single output 24 and a pair of inputs 26, 28. The flip-flop 20 also has a second NAND gate 30 having an output 32 and a pair of inputs 34,36. The input 36 of the second NAND gate 30 is connected to the output 24 of the first NAND gate 22. Similarly, the input 28 of the first NAND gate 22 is connected to the output 32 of the second NAND gate 30.

A second portion of the device 18 includes logic circuitry 38 for converting the NAND R-S flip-flop 20 into a truly bi-stable device. The logic circuitry 38 includes a first inhibit logic 40, the makeup of which will be described later, having a single output 42 and a pair of inputs 44, 46. A pair of terminals $T_1$ and $T_1'$ connects the output 42 of the inhibit logic 40 with the input 26 of the NAND gate 22. The hard wire connection between these two terminals $T_1,T_1'$ is not shown in the drawings.

The logic circuitry 38 also includes a second inhibit logic 48 having an output 50 and a pair of inputs 52,54. A pair of terminals $T_2,T_2'$ connects the output 50 of the inhibit logic 48 with the input 34 of the NAND gate 30. This is also not shown in the drawings.

The input 44 of the first inhibit logic 40 is connected to a terminal for receiving a first input signal $I_1$. Similarly, the input 52 of the second inhibit logic 48 is connected to a second terminal for receiving a second input $I_2$. The input signals $I_1$ and $I_2$, if expressed in binary form and in electrical terms, would have either high or low voltages corresponding to a binary "1" or "0".

The input 46 of the first inhibit logic 40 is also connected to the input 52 of the second inhibit logic 48. Therefore, the inhibit logic 40 receives both the $I_1$ signal through input 44 and the $I_2$ signal through input 46.

In a similar fashion, the input 54 of the second inhibit logic 48 is connected to the input 44 of the first inhibit logic 40. In this manner, the inhibit logic 48 receives the $I_2$ signal through input 52 and the $I_1$ signal through input 54.

Both the first and second inhibit logic 40, 48 are in the form of OR gates each having exactly one inverted input. An inverter 56 converts the binary value of the $I_2$ signal before it is received by the first inhibit logic 40, and another inverter 58 converts the input signal $I_1$ before it is received by the second inhibit logic 48.

Referring now to Fig. 3, therein is shown a second bi-stable device 60 constructed in accordance with another embodiment of the invention. The second device 60 has a first portion which is in the form of a NOR R-S flip-flop 62. The NOR flip-flop 62 includes a first NOR gate 64 having an output 66 and a pair of inputs 68,70. The flip-flop 62 also has a second NOR gate 72 which, in the same fashion, has an output 74 and inputs 76 and 78. The input 70 of the first NOR gate 64 is connected to the output 74 of the second NOR gate 72. The input 78 of the second NOR gate 72 is connected to the output 66 of the first NOR gate 64. The construction and operation of the NOR flip-flop 62 would also be familiar to a person skilled in the art.

A second portion of the device 60 is in the form of logic circuitry 80 which converts the NOR flip-flop 62 into a truly bi-stable device. The logic circuitry 80 includes a first inhibit logic 82 and a second inhibit logic 84. The first inhibit logic 82 has an output 86 and a pair of inputs 88, 90. The second inhibit logic 84 has an output 92 and a pair of inputs 94,96. Both inhibit logic 82 and 84 will be further described later.

In a manner similar to that which was described above for the device 18 in Fig. 2, a pair of terminals $T_1$ and $T_1'$ connect the output 86 of the inhibit logic 82 with the input 68 of the NOR gate 64. Also, a pair of terminals $T_2$ and $T_2'$ connect the output 92 of the second inhibit logic 84 with the input 76 of the NOR gate 72. The actual hard wire connections for these two pairs of terminals are not shown in the drawings.

The input 88 of the inhibit logic 82 is connected to a terminal which receives an input signal $I_1$. Similarly, the input 94 of the inhibit logic 84 is connected to a terminal which receives a second input signal $I_2$. The other input 90 of inhibit logic 82 is also connected to input 94 and therefore receives the other input signal $I_2$ as well. Similarly, the input 96 of the inhibit logic 84 is connected to the input 88 of the inhibit logic 82, for receiving the first input signal $I_1$.

Both the first and second inhibit logic 82, 84 in the second device 60 are in the form of AND gates each having exactly one inverted input. An inverter 98 converts the binary value of the $I_2$ signal before it is received by the first inhibit logic 82, and another inverter 100 converts the input signal $I_1$ before it is received by the second inhibit logic 84.

The logic circuits 38,80 in Figs. 2 and 3 convert the respective NAND and NOR flip-flops 20,62 into truly bi-stable devices. In the two memory devices 18,60, if $R_1 = 1$ then in all cases $R_2 = 0$ and vice versa, meaning that $R_2$ is the binary complement of $R_1$. In other words, no matter what the values of $I_1,I_2$, i.e., (1,1), (1,0), (0,1) or (0,0), the values of $R_1$ and $R_2$ output by the devices 18,60 will be either a (1,0) or (0,1).

The above description is provided for exemplary purposes only. It is to be appreciated that other embodiments may be possible without departing from the spirit and scope of the invention. The invention is not to be limited by the above description. Rather, the invention is to be limited only by the claims which follow, as interpreted in accordance with the doctrines of patent law.

## Claims

1. A bi-stable memory device, comprising:

a first input for receiving a binary input signal $I_1$;

a second input for receiving another binary input signal $I_2$, wherein said $I_1$ signal is normally generated independently of said $I_2$ signal; and

bi-stable logic circuitry means, connected to said first and second inputs to receive said $I_1$ and $I_2$ signals therefrom, and in response thereto, said circuitry means being operable to generate from said $I_1$ and $I_2$ signals both a first binary output response signal $R_1$ and a second binary output response signal $R_2$, wherein said $R_1$ signal is the binary complement of said $R_2$ signal for any binary value of said $I_1$ and $I_2$ input signals received by said circuitry means.

2. The device of claim 1, wherein said logic circuitry means includes a NAND R-S flip-flop (20) having first and second inputs ($T_1'$, $T_2'$), and first and second outputs ($R_1, R_2$), and

a first inhibit logic (40) having an output (42) connected to said first input ($T_1'$) of said flip-flop (20), and having a first logic input (44) connected to said first input of said device, for receiving said $I_1$ signal, and further having a second logic input (46), connected to said second input of said device, for receiving said $I_2$ signal, and including an inverter - (56) operatively positioned in said first inhibit logic (40) for inverting said $I_2$ signal, and

a second inhibit logic (48) having an output (50) connected to said second input ($T_2'$) of said flip-flop (20), and having a first logic input (52) connected to said second input of said device, for receiving said $I_2$ signal, and further having a second logic input (54) connected to said first input of said device, for receiving said $I_1$ signal, and including another inverter (58) operatively positioned in said second inhibit logic (48) for inverting said $I_1$ signal.

3. The device of claim 1, wherein said logic circuitry means includes a NOR R-S flip-flop (62) having first and second inputs ($T_1', T_2'$), and first and second outputs ($R_1, R_2$), and

a first inhibit logic (82) having an output (86) connected to said first input $T_1'$ of said flip-flop (62), and having a first logic input (88) connected to said first input of said device, for receiving said $I_1$ signal, and further having a second logic input (90) connected to said second input of said device, for receiving said $I_2$ signal, and including an inverter - (98) operatively positioned in said first inhibit logic (82) for inverting said $I_2$ signal, and

a second inhibit logic (84) having an output (92) connected to said second input $T_2'$ of said flip-flop (62), and having a first logic input (94) connected to said second input of said device, for receiving said $I_2$ signal, and further having a second logic input (96) connected to said first input of said device, for receiving said $I_1$ signal, and further including an inverter (100) operatively positioned in said inhibit logic (84) for inverting said $I_1$ signal.

*Fig.1A*

*Fig.1B*

Fig.2

Fig.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | ELECTRONIC ENGINEERING, vol. 38, no. 462, August 1966, pages 510-515, London, GB; J.J. SPARKES: "Bistable elements for sequential circuits" * Page 511, right-hand column, line 44 - page 512, right-hand column, line 2; figures 1,2,4 * | 1-3 | H 03 K 3/037 |
| X | PATENTS ABSTRACTS OF JAPAN, vol. 7, no. 84 (E-169)[1229], 8th April 1983; & JP-A-58 10916 (TOKYO SHIBAURA DENKI K.K.) 21-01-1983 * The whole abstract * | 1-3 | |

TECHNICAL FIELDS SEARCHED (Int. Cl.4)

H 03 K

The present search report has been drawn up for all claims

| Place of search | Date of completion of the search | Examiner |
|---|---|---|
| THE HAGUE | 24-11-1986 | CANTARELLI R.J.H. |